# EUROPEAN PATENT APPLICATION

(11) **EP 4 835 175 A1**
(43) Date of publication of application: **04.11.2026**
(21) Application number: 24909873.2
(22) Date of filing: 20.08.2024
(51) Int. Cl.: C30B 29/22, H01M 4/02

(54) **METAL OXIDE PRECURSOR, PREPARATION METHOD THEREFOR, AND USE THEREOF**

(30) Priority: 29.12.2023 CN 202311871680
(71) Applicant: HUAYOU NEW ENERGY TECHNOLOGY (QUZHOU) CO., LTD., Quzhou, Zhejiang 324000 (CN); ZHEJIANG HUAYOU COBALT CO., LTD., Jiaxing, Zhejiang 314000 (CN)
(72) Inventor: ZHAO, Haiying, Quzhou, Zhejiang 324000 (CN); GUO, Xing, Quzhou, Zhejiang 324000 (CN); SHEN, Zhenlei, Quzhou, Zhejiang 324000 (CN); QIU, Tian, Quzhou, Zhejiang 324000 (CN)
(74) Representative: MERH-IP Matias Erny Reichl Hoffmann Patentanwälte PartG mbB
(86) International application number: PCT/CN2024/113454
(87) International publication number: WO 2025/138923

(57) **Abstract**

The present application discloses a metal oxide precursor, a preparation method therefor, and a use thereof. The metal oxide precursor includes: dispersed single-crystal particles, and agglomerate particles formed by some of the single-crystal particles. A dispersion degree K of the metal oxide precursor is 0.467 to 0.917, and K=D₅₀/(η×D₉₀), in which, D₅₀ is a particle size at which a cumulative particle size distribution percentage of the metal oxide precursor reaches 50%, D₉₀ is a particle size at which the cumulative particle size distribution percentage of the metal oxide precursor reaches 90%, and η is a volume deviation coefficient and η=0.6. The metal oxide precursor according to embodiments of the present application has a high dispersion degree and specific surface area, and can be directly used to prepare cathode materials without grinding, crushing, and other treatments, so that the obtained cathode materials have good consistency and stable performance tests.

## Description

The present application claims the priority of the Chinese patent application with application number 202311871680X and titled "Metal oxide precursor, preparation method therefor, and use thereof" filed with the Chinese Patent Office on December 29, 2023, and all the contents thereof are incorporated by reference into the present application.

### TECHNICAL FIELD

The present application relates to the technical field of battery technology, more particularly to a metal oxide precursor, a preparation method therefor, and a use thereof.

### BACKGROUND

The statements here only provide background information related to the present application and do not necessarily constitute prior art. A metal oxide precursor prepared by the traditional spray pyrolysis usually has serious agglomeration phenomenon, resulting in a low specific surface area of the metal oxide precursor, which makes it have low sintering activity, increased energy consumption, and high production cost during the sintering thereof to prepare the cathode material. Therefore, the agglomeration phenomenon of the metal oxide precursor prepared by the traditional spray pyrolysis is usually improved by adding a surfactant or grinding and crushing the metal oxide precursor, but these methods will not only increase the cost and reduce the production efficiency, but also affect the performance test stability of the cathode material. Therefore, it is necessary to provide a highly dispersible metal oxide precursor that can be directly used to prepare cathode materials without grinding, crushing, and other treatments.

### SUMMARY

It is one of objectives of embodiments of the present application to provide a metal oxide precursor, a preparation method therefor, and a use thereof, aiming to provide a highly dispersible metal oxide precursor that can be directly used to prepare cathode materials without grinding, crushing, and other treatments.

Technical solutions adopted by the embodiments of the present application are as follows:

A first aspect provides a metal oxide precursor. The metal oxide precursor comprises: dispersed single-crystal particles, and agglomerate particles formed by some of the single-crystal particles.

A dispersion degree K of the metal oxide precursor is 0.467 to 0.917, and K=D₅₀/(η×D₉₀), in which, D₅₀ is a particle size at which a cumulative particle size distribution percentage of the metal oxide precursor reaches 50%, D₉₀ is a particle size at which the cumulative particle size distribution percentage of the metal oxide precursor reaches 90%, and η is a volume deviation coefficient and η=0.6.

In an embodiment, 1.5 µm ≤ D₅₀ ≤ 4.0 µm.

In an embodiment, 4 µm ≤ D₉₀ ≤ 10 µm.

In an embodiment, the dispersion degree K of the metal oxide precursor is 0.5 to 0.9.

In an embodiment, the dispersion degree K of the metal oxide precursor is 0.6 to 0.8.

In an embodiment, a specific surface area of the metal oxide precursor is 4 m²/g to 12 m²/g.

In an embodiment, an apparent density of the metal oxide precursor is 0.4 g/cm³ to 1.2 g/cm³.

In an embodiment, a tap density of the metal oxide precursor is 1.0 g/cm³ to 2.5 g/cm³.

In an embodiment, an equivalent diameter of the agglomerate particles is 5 to 30 times a particle size of the single-crystal particles.

In an embodiment, in the metal oxide precursor, the dispersion degree of a single agglomerate particle is K=S₂/nS₁, in which, S₁ is a surface area of a single single-crystal particle in single agglomerate particle, n is a number of single-crystal particles in the agglomerate particle, and S₂ is a surface area of the agglomerate particle.

In an embodiment, a chemical formula of the metal oxide precursor is MnₐM₁₋ₐO₂, in which, 0.1 ≤ a ≤ 0.9, and M is selected from at least one of Ni, Fe, Cu, Zn, Co, Mg, Al, and Ti.

In an embodiment, a metal content of the metal oxide precursor is greater than or equal to 70%.

A second aspect of the present application provides a preparation method for the metal oxide precursor. The preparation method adopts spray pyrolysis.

In an embodiment, a pyrolysis temperature of the spray pyrolysis is 500°C to 1000°C.

In an embodiment, a frequency of a feed device of the spray pyrolysis is 25 Hz to 45 Hz.

In an embodiment, a flow rate of the feed device of the spray pyrolysis is 0.3 m³/hr to 0.7 m³/hr.

A third aspect of the present application provides cathode material made from the above metal oxide precursor or a metal oxide precursor prepared by the above preparation method.

A fourth aspect of the present application provides a cathode plate, comprising: a cathode current collector, and a cathode material layer, which is disposed on a surface of the cathode current collector and comprises the above cathode material.

A fifth aspect of the present application provides a secondary battery, comprising the above cathode plate.

Advantages of the metal oxide precursor provided in embodiments of the present application are summarized as follows: the dispersion degree K of the metal oxide precursor is 0.467 to 0.917. At this specific dispersion degree, on the one hand, the agglomeration phenomenon of the metal oxide precursor is effectively reduced, and the metal oxide precursor can be directly used to prepare the cathode material without grinding, crushing, and other treatments. Even if some agglomerate particles exist, since the metal oxide precursor has a certain dispersion degree, the agglomerate particles are also very easy to disperse completely during the preparation of the cathode material. This is conducive to improving the uniform effect of the mixing, so that the obtained cathode material has good consistency, which is not only conducive to improving the performance test stability of the cathode material, but also conducive to reducing the cost and improving the production efficiency. On the other hand, the metal oxide precursor has a relatively high specific surface area, which is beneficial to improving the sintering activity thereof during the preparation into cathode material, thereby reducing production energy consumption.

Advantages of the preparation method for the metal oxide precursor provided in embodiments of the present application are summarized as follows: the metal oxide precursor can be prepared by spray pyrolysis, and the dispersion degree K of the prepared metal oxide precursor is 0.467 to 0.917, which effectively reduces the agglomeration phenomenon of the metal oxide precursor, making the prepared metal oxide precursor can be directly used to prepare the cathode material without grinding, crushing, and other treatments. In addition, the metal oxide precursor has a relatively high specific surface area, which is beneficial to improving the sintering activity thereof during the preparation into cathode material, thereby reducing production energy consumption.

Advantages of the cathode material provided in embodiments of the present application are summarized as follows: when the metal oxide precursor of the embodiments of the present application is used to prepare the cathode material, and it is easier to obtain a single-crystal cathode material with good uniformity, which is beneficial to improving the discharge capacity and cycle performance of the cathode material.

Advantages of the cathode plate provided in embodiments of the present application are summarized as follows: the cathode material layer of the cathode plate of the embodiments of the present application includes the above-mentioned cathode material with improved discharge capacity and cycle performance, thereby improving the energy density, cycle stability, and other electrochemical properties of the cathode plate.

Advantages of the secondary battery provided in embodiments of the present application are summarized as follows: the cathode plate with high energy density, cycle stability, and other characteristics provided by the above embodiments of the present application is applied to the secondary battery, which can improve the electrochemical properties of the secondary battery such as cycle stability and cycle life.

### DESCRIPTION OF THE DRAWINGS

In order to more clearly illustrate the technical solutions in the embodiment of the present application, the drawings required for use in the embodiments or exemplary technical description will be briefly introduced below. Obviously, the drawings described below are only some embodiments of the present application. For ordinary technicians in this field, other drawings can also be obtained based on these drawings without creative work.
FIG. 1 is a scanning electron microscope image of a metal oxide precursor prepared in Example 1 of the present application;
FIG. 2 is a scanning electron microscope image of a metal oxide precursor prepared in Example 2 of the present application;
FIG. 3 is a scanning electron microscope image of a metal oxide precursor prepared in Comparative Example 1 of the present application; and
FIG. 4 is a scanning electron microscope image of a metal oxide precursor prepared in Comparative Example 2 of the present application.

### DETAILED DESCRIPTION OF THE EMBODIMENTS

In order to clarify the objectives, technical solutions, and advantages of the present application, the present application is further described in detail below in combination with the drawings and embodiments. It should be understood that the specific embodiments described herein are only used to explain the present invention and are not intended to limit the present application.

It should be noted that when a component is referred to as being "fixed to" or "arranged on" another component, it can be directly on the other component or indirectly on the other component. When a component is referred to as being "connected to" another component, it can be directly or indirectly connected to the other component. The orientation or position relationship indicated by the terms "upper", "lower", "left", "right", etc. is based on the orientation or position relationship shown in the drawings, and is only for the convenience of description, and does not indicate or imply that the device or element referred to must have a specific orientation, be constructed and operated in a specific orientation. Therefore, it cannot be understood as a limitation of the present application. For ordinary technicians in this field, the specific meanings of the above terms can be understood according to specific circumstances. The terms "first" and "second" are only used for the purpose of convenience of description, and cannot be understood as indicating or implying relative importance or implicitly indicating the number of technical features. "Multiple" means two or more, unless otherwise clearly and specifically defined.

Unless otherwise defined, all technical and scientific terms used herein have the same meaning as those generally understood by technicians in the technical field of the embodiments of the present application. The terms used in the specification of the embodiments of the present application are only for the purpose of describing specific implementation methods or embodiments, and are not intended to limit the embodiments of the present application. The optional range of the term "and/or" used in this article includes any one of two or more related listed items, and also includes any and all combinations of related listed items, and any and all combinations include any two related listed items, any more related listed items, or all related listed items.

In order to illustrate the technical solution of the present application, the following is a detailed description in conjunction with specific drawings and embodiments.

Embodiments of the present application provide a metal oxide precursor, which includes dispersed single-crystal particles, and agglomerate particles formed by some of the single-crystal particles.

A dispersion degree K of the metal oxide precursor is 0.467 to 0.917, and K=D₅₀/(η×D₉₀), in which, D₅₀ is a particle size at which a cumulative particle size distribution percentage of the metal oxide precursor reaches 50%, D₉₀ is a particle size at which the cumulative particle size distribution percentage of the metal oxide precursor reaches 90%, and η is a volume deviation coefficient and η=0.6.

It should be noted that, in theory, when there is no agglomeration, the metal oxide precursor has the maximum specific surface area; when partial agglomeration occurs between particles, the closer the agglomerated particles are and the smaller the gaps are, the more serious the agglomeration is, resulting in a smaller specific surface area.

Based on this, in this embodiment of the present application, the dispersion degree K of the metal oxide precursor is defined as a ratio of an actual specific surface area of the agglomerate to a theoretical specific surface area of the constituent particles of the agglomerate in the dispersed state in the metal oxide precursor. In the metal oxide precursor, the dispersion degree K of a single agglomerate particle is K=S₂/nS₁, where S₁ is a surface area of a single constituent particle (i.e., single-crystal particle) in the agglomerate particle, n is the number of constituent particles (i.e., single-crystal particles) in the agglomerate particle, and S₂ is the surface area of the agglomerate particle.

The D₅₀ value represents the particle size corresponding to the dispersed particles, and the D₉₀ value represents the particle size corresponding to the agglomerated particles. Under the condition that the density of the same material remains unchanged, the mass of the same volume of material is equal, and then n=η×(D₉₀)³/(D₅₀)³ is derived through the volume ratio. Considering that the pores between the agglomerated particles will cause a certain deviation in volume, the volume deviation coefficient is set to be η=0.6, and S₁ and S₂ are derived according to D₅₀ and D₉₀ to obtain K=D₅₀/(η×D₉₀). The volume deviation coefficient η is based on the equivalent diameter of the agglomerated particles being 5 to 30 times that of the single-crystal particles, and the porosity is inferred from two-dimensional and three-dimensional perspectives, so the volume deviation coefficient η takes an average value of 0.6.

The dispersion degree K of the metal oxide precursor in the embodiment of the present application is 0.467 to 0.917. When the dispersion degree K is in the range of 0.467 to 0.917, the particles are well dispersed and the agglomeration phenomenon is less. When K>0.467, it means that a considerable part of the particles in the system are dispersed. As the K value increases, the proportion of dispersed particles increases, and the proportion of agglomerates decreases. Within this range, the interaction force between particles decreases, and the particles tend to remain dispersed. The higher the dispersion degree K, the more the particles can fully expose their surface area, so the surface area contribution of a single particle is greater. When K is 0.917, almost all particles are in a dispersed state, the effective surface area participating in the electrochemical reaction increases, and the electrochemical reaction activity of the material is the highest. The dispersion degree K of the metal oxide precursor is 0.467 to 0.917. At this specific dispersion degree, on the one hand, the agglomeration phenomenon of the metal oxide precursor is effectively reduced, and the metal oxide precursor can be directly used to prepare the cathode material without grinding, crushing, and other treatments. Even if some agglomerate particles exist, since the metal oxide precursor has a certain dispersion degree, the agglomerate particles are also very easy to disperse completely during the preparation of the cathode material. This is conducive to improving the uniform effect of the mixing, so that the obtained cathode material has good consistency, which is not only conducive to improving the performance test stability of the cathode material, but also conducive to reducing the cost and improving the production efficiency. On the other hand, the metal oxide precursor has a relatively high specific surface area, which is beneficial to improving the sintering activity thereof during the preparation into cathode material, thereby reducing production energy consumption.

In an embodiment, the particle size at which the cumulative particle size distribution percentage of the metal oxide precursor reaches 50% can be 1.5 µm to 4.0 µm, that is, 1.5 µm ≤ D₅₀ ≤ 4.0 µm. Exemplarily, the particle size at which the cumulative particle size distribution percentage of the metal oxide precursor reaches 50% may be any typical but non-limiting point values such as 1.5 µm, 2 µm, 2.5 µm, 3 µm, 3.5 µm, 4 µm, or any interval values between any two point values. In the condition of the above D₅₀, D₅₀ is used to represent the average particle size of the single-crystal particles. When D₅₀ is smaller, a surface energy of the particles is larger, and the particles tend to agglomerate to reduce the surface energy. Agglomeration will reduce the specific surface area, and then the smaller D₅₀ is, the worse the dispersion is, that is, K is closer to 0. D₅₀ is preferably 1.5 µm to 4.0 µm, due that excessively small particle sizes would exhibit high surface energy, tending to induce particle agglomeration, and would present higher grain boundary ratios that may introduce more grain boundary defects, thereby compromising structural stability, while excessively large particle sizes would prolong lithium-ion diffusion paths, adversely affecting battery rate capability, and would potentially lead to difficulties in the electrochemical reaction to proceed uniformly.

In an embodiment, the particle size at which the cumulative particle size distribution percentage of the metal oxide precursor reaches 90% can be 4 µm to 10 µm, that is, 4 µm ≤ D₉₀ ≤ 10 µm. Exemplarily, the particle size at which the cumulative particle size distribution percentage of the metal oxide precursor reaches 90% may be any typical but non-limiting point values such as 4 µm, 5 µm, 6 µm, 7 µm, 8 µm, 9 µm, 10 µm, or any interval values between any two point values. In the condition of the above D₉₀, D₉₀ is used to represent the equivalent diameter of the agglomerate. The larger the D₉₀, the more serious the agglomeration phenomenon, the smaller the specific surface area, and the worse the dispersion. There is a correlation between the size of D₅₀ and D₉₀. The larger the D₅₀ of the particle, the larger its relative D₉₀. When D₉₀ is close to D₅₀, it means that the degree of agglomeration is lighter, that is, the higher the dispersion. D₉₀ is preferably 4 µm to 10 µm, which corresponds to the selected value of D₅₀. D₅₀ cannot be too small, so the lower limit is 4 µm. D₉₀ is too large, which means that the agglomeration is serious, resulting in uneven particle size and distribution, affecting the electrochemical performance.

In embodiments of the present application, by adjusting the D₅₀ and D₉₀ of the metal oxide precursor, it is conducive to ensuring that the metal oxide precursor can meet the provided dispersion degree K=D₅₀/(η×D₉₀) and makes the dispersion degree of the metal oxide precursor reach 0.467 to 0.917. Exemplarily, the dispersion degree K of the metal oxide precursor may be any typical but non-limiting point values such as 0.467, 0.5, 0.6, 0.7, 0.8, 0.9, 0.917, or any interval values between any two point values.

In some embodiments, the dispersion degree K of the metal oxide precursor is 0.5 to 0.9. In other embodiments, the dispersion degree K of the metal oxide precursor is 0.6 to 0.8. In the above embodiments of the present application, the dispersion degree K of the metal oxide precursor can better make the metal oxide precursor easy to disperse completely in the process of preparing the cathode material, thereby achieving the effect of improving the performance test stability of the cathode material, reducing costs, and improving production efficiency.

In an embodiment, a specific surface area of the metal oxide precursor is 4 m²/g to 12 m²/g. Exemplarily, the specific surface area of the metal oxide precursor may be any typical but non-limiting point values such as 4 m²/g, 5 m²/g, 6 m²/g, 7 m²/g, 8 m²/g, 9 m²/g, 10 m²/g, 11 m²/g, 12 m²/g, or any interval values between any two point values. The dispersion degree K of the metal oxide precursor in the embodiments of the present application is 0.467 to 0.917, so that the metal oxide precursor has a higher specific surface area. The relationship between the dispersion degree K and the specific surface area S can be expressed as $K = \frac{\begin{matrix}n 2 ⋅ S 2 \\ m\end{matrix}}{\begin{matrix}n 1 ⋅ S 1 \\ m\end{matrix}} = \frac{n 2 ⋅ S 2}{n 1 ⋅ S 1} = \frac{S 2}{n ⋅ S 1}$, in which, S1 is the surface area corresponding to a single particle, S2 is the surface area corresponding to a single agglomerate, the more severe the agglomeration, the smaller the specific surface area, the closer the K value is to 0; and the closer the K value is to 1, the better the particle dispersion, and when K=1, it is indicated complete dispersion.

In an embodiment, an apparent density of the metal oxide precursor is 0.4 g/cm³ to 1.2 g/cm³. Exemplarily, the apparent density of the metal oxide precursor may be any typical but non-limiting point values such as 0.4 g/cm³, 0.5 g/cm³, 0.6 g/cm³, 0.7 g/cm³, 0.8 g/cm³, 0.9 g/cm³, 1.0 g/cm³, 1.1 g/cm³, 1.2 g/cm³, or any interval values between any two point values. The dispersion degree K of the metal oxide precursor of the embodiment of the present application is 0.467 to 0.917, so that the metal oxide precursor has a higher apparent density. If the dispersion degree is too low, the particles are seriously and irregularly agglomerated, which affects the stacking behavior of the particles. Although the agglomerates are tight inside, the gaps between the agglomerates are large, resulting in a low apparent density. If the dispersion degree is too high, there are more gaps between the dispersed particles, resulting in a decrease in the packed density of the overall stacking. The metal oxide precursor of the present application has a dispersion degree K of between 0.467 and 0.917, and contains a small amount of agglomerates along with dispersed particles. Small particles are filled in large pores, which is beneficial to improving the apparent density. In this range, the apparent density increases first and then decreases with the increase of K.

In an embodiment, the tap density of the metal oxide precursor is 1.0 g/cm³ to 2.5 g/cm³. Exemplarily, the tap density of the metal oxide precursor may be any typical but non-limiting point values such as 1.0 g/cm³, 1.2 g/cm³, 1.4 g/cm³, 1.5 g/cm³, 1.6 g/cm³, 1.8 g/cm³, 2.0 g/cm³, 2.2 g/cm³, 2.4 g/cm³, 2.5 g/cm³, or any interval values between any two point values. The dispersion degree K of the metal oxide precursor of the embodiment of the present application is 0.467 to 0.917, so that the metal oxide precursor has a higher tap density, which is consistent with the relationship between K and the apparent density as mentioned above. In the range of the dispersion degree K of 0.467 to 0.917, the tap density increases first and then decreases with the increase of K.

In the embodiment of the present application, on the basis of satisfying the provided dispersion degree K=D₅₀/(η×D₉₀), the metal oxide precursor has a better dispersion degree and contains agglomerated and dispersed particles, which helps to fill the gaps and thus improve the tap density and the compacted density. The metal oxide precursor can be made easier to disperse in the process of preparing the cathode material, which is beneficial to the uniformity of the cathode coating, thereby improving the performance test stability of the cathode material, and is beneficial to reducing costs and improving production efficiency.

In an embodiment, an equivalent diameter of the agglomerate particles is 5 to 30 times the particle size of the single-crystal particles. Exemplarily, the fold values may be any typical but non-limiting point values such as 5 times, 6 times, 8 times, 10 times, 15 times, 20 times, 25 times, 30 times, or any interval values between any two point values. In this case, if the agglomerate is too large, the electrochemical reaction is uneven, and the diffusion path of lithium ions is long, which affects the rate performance. If the particle dispersion is too high, it is not conducive to improving the apparent density and tap density, resulting in a decrease in the capacity and energy density of the battery.

In the embodiment of the present application, on the basis of the metal oxide precursor satisfying the provided dispersion degree K=D₅₀/(η×D₉₀), by regulating the agglomeration size of the agglomerate formed by the single-crystal particles, D₉₀ is close to D₅₀, which is beneficial to the uniformity of the cathode coating, so that the metal oxide precursor can be directly used to prepare the cathode material without grinding, crushing, and other treatments.

In an embodiment, the chemical formula of the metal oxide precursor is expressed as MnₐM₁₋ₐO₂, in which, 0.1 ≤ a ≤ 0.9, and M is selected from at least one of Ni, Fe, Cu, Zn, Co, Mg, Al, and Ti. It can be understood that the metal oxide precursor in the embodiments of the present application may be a binary metal oxide, a ternary metal oxide, or a quaternary metal oxide, which is not limited herein in the embodiments of the present application.

In an embodiment, a metal content of the metal oxide precursor is greater than or equal to 70%, which not only increases the packaging volume, thereby reducing the transportation cost, but also increases a loading amount when being used in the preparation of the cathode material of the sodium ion battery, thereby facilitating the increase of production capacity and reducing energy consumption. Exemplarily, the metal content of the metal oxide precursor may be may be any typical but non-limiting point values such as 70%, 75%, 80%, 85%, 90%, 95%, or any interval values between any two point values.

The embodiment of the present application provides a method for preparing the above metal oxide precursor, and the preparation method is selected from the spray pyrolysis.

The metal oxide precursors in the embodiments of the present application can be prepared by spray pyrolysis, and the dispersion degree K of the obtained metal oxide precursors is 0.467 to 0.917, which effectively reduces the agglomeration phenomenon of the metal oxide precursor, making the prepared metal oxide precursor can be directly used to prepare the cathode material without grinding, crushing, and other treatments. In addition, the metal oxide precursor has a relatively high specific surface area, which is beneficial to improving the sintering activity thereof during the preparation into cathode material, thereby reducing production energy consumption.

It should be noted that the specific operation of the spray pyrolysis can refer to the existing method, which will not be repeated herein in the embodiments of the present application.

In an embodiment, a pyrolysis temperature of the spray pyrolysis is 500°C to 1000°C. Exemplarily, the pyrolysis temperature of the spray pyrolysis may be any typical but non-limiting point values such as 500°C, 600°C, 700°C, 800°C, 900°C, or any interval values between any two point values. Under these pyrolysis temperature conditions, at lower pyrolysis temperatures, the particles exhibit poorer crystallinity, non-uniform formation processes, smaller particle sizes with irregular morphologies, and a tendency to agglomerate, resulting in inferior dispersibility. At higher pyrolysis temperatures, the particles demonstrate improved crystallinity, larger particle sizes with more regular morphologies, more uniform size distribution, and enhanced dispersibility.

In an embodiment, the frequency of the feed device of the spray pyrolysis is 25 Hz to 45 Hz, which can be 35 Hz to 40 Hz; for example, the frequency of the feed device of the spray pyrolysis may be any typical but non-limiting point values such as 25 Hz, 30 Hz, 35 Hz, 40 Hz, 45 Hz, or any interval values between any two point values. Under this feeding frequency condition: at a low feeding frequency, the droplets undergo sufficient thermal decomposition, resulting in uniform particle size distribution and improved dispersibility, thereby effectively reducing interparticle agglomeration. At a high feeding frequency, the droplets experience non-uniform heating, leading to poor particle dispersibility. This tends to form irregular particle size distribution and promotes agglomeration phenomena, consequently deteriorating dispersion performance.

In an embodiment, the flow rate of the feed device of the spray pyrolysis is 0.3 m³/hr to 0.7 m³/hr , which can be 0.35 m³/hr to 0.55 m³/hr. Exemplarily, the flow rate of the feed device of the spray pyrolysis may be any typical but non-limiting point values such as 0.3 m³/hr , 0.4 m³/hr , 0.5 m³/hr , 0.6 m³/hr , 0.7 m³/hr, or any interval values between any two point values. Under the flow conditions of this feed device, when the feed flow rate is low, there are fewer atomized droplets. This results in more thorough thermal decomposition, more uniform particle size, regular morphology, less agglomeration, and better dispersion. When the feed flow rate is high, there are more atomized droplets, leading to insufficient particle growth. This causes uneven particle size, increased agglomeration, and poorer dispersion.

By regulating the pyrolysis temperature, feed frequency, feed flow rate and other conditions, it is beneficial to improving the dispersion of the obtained metal oxide precursor and effectively improve the agglomeration phenomenon.

It should be noted that the pyrolysis temperature refers to the operating temperature of the pyrolysis device. If the frequency of the feed device at 50 Hz is considered equivalent to 100%, then a frequency of 25 Hz to 45 Hz for the feed device corresponds to 50% to 90% of 50 Hz; and a frequency of 35 Hz to 40 Hz corresponds to 70% to 80% of 50 Hz. The preparation method can meet the above conditions, including pyrolysis temperature, feed frequency, and feed flow rate. However, it should be understood that other preparation methods that do not satisfy these conditions may still enable the metal oxide precursor to achieve the specific dispersion degree described in the embodiments of this application under certain circumstances. The embodiments of this application do not impose limitations in this regard.

Embodiments of the present application also provide a cathode material made from the above metal oxide precursor.

The metal oxide precursor of the embodiments of the present application is used to prepare the cathode material, which is easier to obtain a single-crystal cathode material with good uniformity, and is beneficial to improving the discharge capacity and cycle performance of the cathode material.

It should be noted that the preparation method for the cathode material refers to the existing method, which will not be repeated herein in the embodiments of the present application.

Embodiments of the present application further provide a cathode plate, including a cathode current collector and a cathode material layer disposed on a surface of the cathode current collector. The cathode material layer includes the above-mentioned cathode material.

The cathode material layer of the cathode plate of the embodiments of the present application includes the above-mentioned cathode material with the improved discharge capacity and cycle performance, thereby improving the energy density, cycle stability, and other electrochemical properties of the cathode plate.

Embodiments of the present application further provide a secondary battery, including the above-mentioned cathode plate.

In the embodiments of the present application, the cathode plate having high energy density, cycle stability, and other characteristics is applied to a secondary battery, which can improve the electrochemical properties of the secondary battery, such as cycle stability and cycle life.

For example, the secondary battery can be a sodium ion battery.

In an embodiment, the cathode current collector can be a metal foil or a composite current collector, for example, aluminum foil is used as the metal foil; the composite current collector can be formed by forming a metal material on a polymer material substrate. The metal material includes but is not limited to at least one of aluminum, aluminum alloy, nickel, nickel alloy, titanium, titanium alloy, silver and silver alloy, and the polymer material substrate includes but is not limited to at least one of polypropylene (PP), polyethylene terephthalate (PET), polybutylene terephthalate (PBT), polystyrene (PS) and polyethylene (PE).

It can be understood that the cathode material layer also includes a binder and a conductive agent. The binder may be any commercially available binder for cathode plates, including but not limited to at least one of polyvinylidene fluoride (PVDF), polytetrafluoroethylene (PTFE), vinylidene fluoride-tetrafluoroethylene-propylene terpolymer, vinylidene fluoride-fluoropropylene-tetrafluoroethylene terpolymer, tetrafluoroethylene-hexafluoropropylene copolymer, and fluorine-containing acrylate resin, or a binder prepared by any known method, which is not limited to in the embodiments of the present application; The conductive agent may be any commercially available conductive agent for sodium ion batteries, such as carbon black, graphite, etc.

Hereinbelow, a metal oxide precursor, a preparation method therefor, and a use thereof will be further described through the following specific examples. However, those skilled in the art will understand that the following examples are only used to illustrate the embodiments of the present application and should not be regarded as limiting the scope of the embodiments of the present application. If the specific conditions are not specified in the examples, they shall be carried out according to conventional conditions or conditions recommended by the manufacturer. The reagents or instruments used without indicating the manufacturer are all conventional products that can be purchased commercially.

### Example 1

A nickel salt, an iron salt, and a manganese salt were mixed in a molar ratio of 1:1:1 (based on metal atoms) to prepare a mixed metal salt solution, and then the mixed metal salt solution was introduced into the roasting furnace in the form of droplets at a liquid feed flow rate of 0.5 m³/hr and a feed frequency of 37.5 Hz. Under a pyrolysis temperature of 750°C, the droplets underwent evaporation, drying, thermal decomposition, sintering, and other processes to form the metal oxide precursor. The obtained metal oxide precursor product was represented by a simplified formula NFM111.

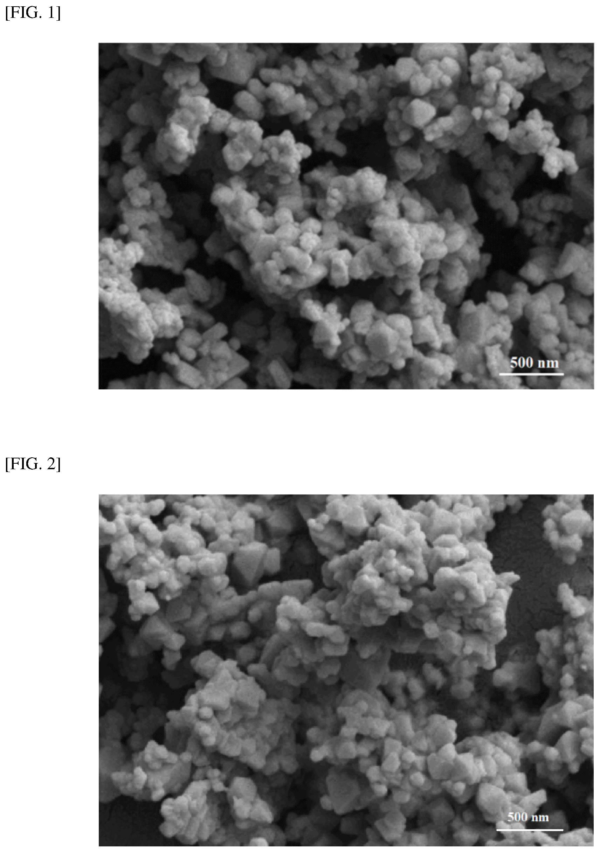

The surface morphology of the metal oxide precursor obtained in this example is shown in FIG. 1. It can be seen that the metal oxide precursor contains single-crystal particles and partial agglomerates formed by irregular agglomeration of a part of the single-crystal particles. An equivalent diameter of the agglomerates is about 17 to 24 times the particle size of the single-crystal particles.

It was found from testing that the metal oxide precursor had a D₅₀ of 2.58 µm, a D₉₀ of 5.98 µm, an apparent density (AD) of 0.67 g/cm³, a tap density (TD) of 1.52 g/cm³, and a specific surface area (BET) of 4.43 m²/g.

Through simulation calculation, it was found that the dispersion degree K of metal oxide precursor prepared in this example was 0.719.

### Example 2

An iron salt, and a manganese salt were mixed in a molar ratio of 4:6 (based on metal atoms) to prepare a mixed metal salt solution, and then the mixed metal salt solution was introduced into the roasting furnace in the form of droplets at a liquid feed flow rate of 0.6 m³/hr and a feed frequency of 33.5 Hz. Under a pyrolysis temperature of 860°C, the droplets underwent evaporation, drying, thermal decomposition, sintering, and other processes to form the metal oxide precursor. The obtained metal oxide precursor product was represented by a simplified formula FM46.

The surface morphology of the metal oxide precursor obtained in this example is shown in FIG. 2. It can be seen that the metal oxide precursor contains single-crystal particles and partial agglomerates formed by irregular agglomeration of a part of the single-crystal particles. An equivalent diameter of the agglomerates is about 12 to 18 times the particle size of the single-crystal particles.

It was found from testing that the metal oxide precursor had a D₅₀ of 1.98 µm, a D₉₀ of 4.25 µm, an apparent density (AD) of 0.74 g/cm³, a tap density (TD) of 1.84 g/cm³, and a specific surface area (BET) of 6.87 m²/g.

Through simulation calculation, it was found that the dispersion degree K of metal oxide precursor prepared in this example was 0.776.

### Example 3

A nickel salt, a copper salt, an iron salt, and a manganese salt were mixed in a molar ratio of 2:1:3:3 (based on metal atoms) to prepare a mixed metal salt solution, and then the mixed metal salt solution was introduced into the roasting furnace in the form of droplets at a liquid feed flow rate of 0.3 m³/hr and a feed frequency of 25 Hz. Under a pyrolysis temperature of 1000°C, the droplets underwent evaporation, drying, thermal decomposition, sintering, and other processes to form the metal oxide precursor. The obtained metal oxide precursor product was represented by a simplified formula NCFM2133.

Through SEM testing, it can be seen that the metal oxide precursor contains single-crystal particles and partial agglomerates formed by irregular agglomeration of a part of the single-crystal particles. An equivalent diameter of the agglomerates is about 15 to 20 times the particle size of the single-crystal particles.

It was found from testing that the metal oxide precursor had a D₅₀ of 3.84 µm, a D₉₀ of 8.67 µm, an apparent density (AD) of 0.82 g/cm³, a tap density (TD) of 1.93 g/cm³, and a specific surface area (BET) of 9.69 m²/g.

Through simulation calculation, it was found that the dispersion degree K of metal oxide precursor prepared in this example was 0.738.

### Example 4

A copper salt, an iron salt, and a manganese salt were mixed in a molar ratio of 4:2:4 (based on metal atoms) to prepare a mixed metal salt solution, and then the mixed metal salt solution was introduced into the roasting furnace in the form of droplets at a liquid feed flow rate of 0.7 m³/hr and a feed frequency of 45 Hz. Under a pyrolysis temperature of 520°C, the droplets underwent evaporation, drying, thermal decomposition, sintering, and other processes to form the metal oxide precursor. The obtained metal oxide precursor product was represented by a simplified formula CFM424.

Through SEM testing, it can be seen that the metal oxide precursor contains single-crystal particles and partial agglomerates formed by irregular agglomeration of a part of the single-crystal particles. An equivalent diameter of the agglomerates is about 24 to 30 times the particle size of the single-crystal particles.

It was found from testing that the metal oxide precursor had a D₅₀ of 1.56 µm, a D₉₀ of 4.21 µm, an apparent density (AD) of 0.46 g/cm³, a tap density (TD) of 1.08 g/cm³, and a specific surface area (BET) of 4.39 m²/g.

Through simulation calculation, it was found that the dispersion degree K of metal oxide precursor prepared in this example was 0.618.

### Example 5

A nickel slat, a cobalt salt, and a manganese salt were mixed in a molar ratio of 6:1:3 (based on metal atoms) to prepare a mixed metal salt solution, and then the mixed metal salt solution was introduced into the roasting furnace in the form of droplets at a liquid feed flow rate of 0.7 m³/hr and a feed frequency of 40 Hz. Under a pyrolysis temperature of 610°C, the droplets underwent evaporation, drying, thermal decomposition, sintering, and other processes to form the metal oxide precursor. The obtained metal oxide precursor product was represented by a simplified formula NCM613.

Through SEM testing, it can be seen that the metal oxide precursor contains single-crystal particles and partial agglomerates formed by irregular agglomeration of a part of the single-crystal particles. An equivalent diameter of the agglomerates is about 22 to 30 times the particle size of the single-crystal particles.

It was found from testing that the metal oxide precursor had a D₅₀ of 2.15 µm, a D₉₀ of 7.64 µm, an apparent density (AD) of 0.47 g/cm³, a tap density (TD) of 1.23 g/cm³, and a specific surface area (BET) of 4.98 m²/g.

Through simulation calculation, it was found that the dispersion degree K of metal oxide precursor prepared in this example was 0.915.

### Example 6

A nickel slat, a cobalt salt, and a manganese salt were mixed in a molar ratio of 6:1:3 (based on metal atoms) to prepare a mixed metal salt solution, and then the mixed metal salt solution was introduced into the roasting furnace in the form of droplets at a liquid feed flow rate of 03 m³/hr and a feed frequency of 25 Hz. Under a pyrolysis temperature of 920°C, the droplets underwent evaporation, drying, thermal decomposition, sintering, and other processes to form the metal oxide precursor. The obtained metal oxide precursor product was represented by a simplified formula NCM613.

Through SEM testing, it can be seen that the metal oxide precursor contains single-crystal particles and partial agglomerates formed by irregular agglomeration of a part of the single-crystal particles. An equivalent diameter of the agglomerates is about 5 to 12 times the particle size of the single-crystal particles.

It was found from testing that the metal oxide precursor had a D₅₀ of 3.98 µm, a D₉₀ of 7.25 µm, an apparent density (AD) of 0.46 g/cm³, a tap density (TD) of 1.13 g/cm³, and a specific surface area (BET) of 11.3 m²/g.

Through simulation calculation, it was found that the dispersion degree K of metal oxide precursor prepared in this example was 0.469.

### Comparative Example 1

A nickel salt, an iron salt, and a manganese salt were mixed in a molar ratio of 1:1:1 (based on metal atoms) to prepare a mixed metal salt solution, and then the mixed metal salt solution was introduced into the roasting furnace in the form of droplets at a liquid feed flow rate of 0.75 m³/hr and a feed frequency of 35 Hz. Under a pyrolysis temperature of 1050°C, the droplets underwent evaporation, drying, thermal decomposition, sintering, and other processes to form the metal oxide precursor. The obtained metal oxide precursor product was represented by a simplified formula NFM111.

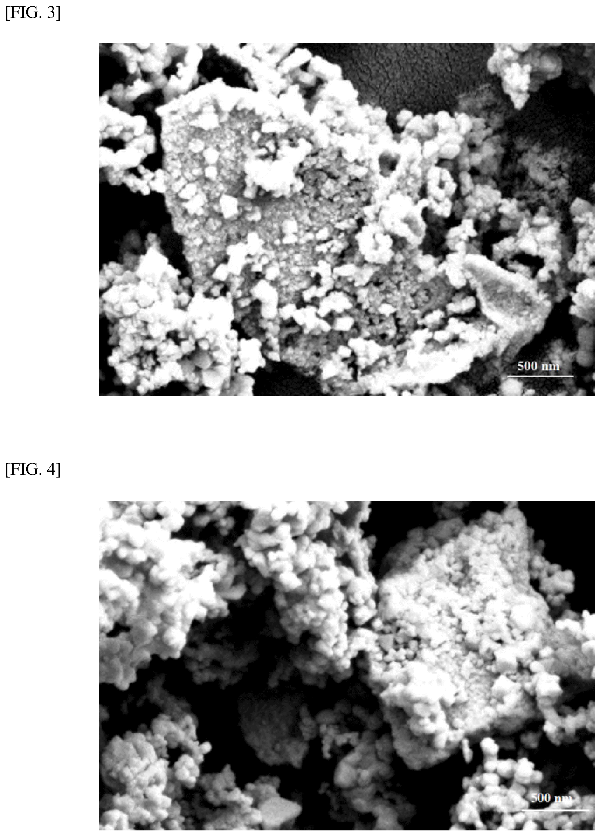

A surface morphology of the metal oxide precursor obtained in this example is shown in FIG. 3. It can be seen that the metal oxide precursor has serious agglomeration phenomenon, and the equivalent diameter of the agglomerate is about 28 to 45 times the particle size of the single-crystal particle.

It was found from testing that the metal oxide precursor had a D₅₀ of 4.6 µm, a D₉₀ of 17.32 µm, an apparent density (AD) of 0.35 g/cm³, a tap density (TD) of 0.94 g/cm³, and a specific surface area (BET) of 2.98 m²/g.

Through simulation calculation, it was found that the dispersion degree K of metal oxide precursor prepared in this example was only 0.443.

### Comparative Example 2

A nickel salt, a copper salt, an iron salt, and a manganese salt were mixed in a molar ratio of 2:1:3:3 (based on metal atoms) to prepare a mixed metal salt solution, and then the mixed metal salt solution was introduced into the roasting furnace in the form of droplets at a liquid feed flow rate of 0.28 m³/hr and a feed frequency of 23.5 Hz. Under a pyrolysis temperature of 480°C, the droplets underwent evaporation, drying, thermal decomposition, sintering, and other processes to form the metal oxide precursor. The obtained metal oxide precursor product was represented by a simplified formula NCFM2133.

A surface morphology of the metal oxide precursor obtained in this example is shown in FIG. 4. It can be seen that the metal oxide precursor has serious agglomeration phenomenon, and the equivalent diameter of the agglomerate is about 35 to 50 times the particle size of the single-crystal particle.

It was found from testing that the metal oxide precursor had a D₅₀ of 0.85 µm, a D₉₀ of 3.15 µm, an apparent density (AD) of 0.36 g/cm³, a tap density (TD) of 0.97 g/cm³, and a specific surface area (BET) of 3.38 m²/g.

Through simulation calculation, it was found that the dispersion degree K of metal oxide precursor prepared in this example was only 0.45.

### Comparative Example 3

A nickel salt, an iron salt, and a manganese salt were mixed in a molar ratio of 1:1:1 (based on metal atoms) to prepare a mixed metal salt solution, and then the mixed metal salt solution was introduced into the roasting furnace in the form of droplets at a liquid feed flow rate of 0.75 m³/hr and a feed frequency of 40 Hz. Under a pyrolysis temperature of 450°C, the droplets underwent evaporation, drying, thermal decomposition, sintering, and other processes to form the metal oxide precursor. The obtained metal oxide precursor product was represented by a simplified formula NFM111.

Through SEM testing, it can be seen that the metal oxide precursor contains single-crystal particles and partial agglomerates formed by irregular agglomeration of a part of the single-crystal particles. An equivalent diameter of the agglomerates is about 5 to 10 times the particle size of the single-crystal particles.

It was found from testing that the metal oxide precursor had a D₅₀ of 1.8 µm, a D₉₀ of 3.16 µm, an apparent density (AD) of 0.41 g/cm³, a tap density (TD) of 0.95 g/cm³, and a specific surface area (BET) of 6.9 m²/g.

Through simulation calculation, it was found that the dispersion degree K of metal oxide precursor prepared in this example was 0.95.

### Application Example

The metal oxide precursors obtained in Examples 1-6 and Comparative Examples 1-3 each were respectively mixed with sodium carbonate at a molar ratio of 1:1. A resulting mixture was then placed in a muffle furnace, heated to 900°C at a heating rate of 5°C/min under an air atmosphere, and sintered at a constant temperature for 15 hrs. After natural cooling, the product was crushed and sieved to obtain the cathode material.

The prepared cathode materials was used to assemble a sodium-ion coin cell. The capacity retention rate after 50 cycles was tested under a voltage range of 2 V to 4.15 V, and the results are shown in Table 1.

**Table 1**

| [Table1_sm_0001] | |
|---|---|
| | Capacity retention rate after 50 cycles (%) |
| Example 1 | 94.5 |
| Example 2 | 91.6 |
| Example 3 | 90.0 |
| Example 4 | 92.5 |
| Example 5 | 89.7 |
| Example 6 | 88.5 |
| Comparative Example 1 | 79.0 |
| Comparative Example 2 | 72.0 |
| Comparative Example 3 | 70.3 |

According to Table 1, the metal oxide precursors prepared in Examples 1-6, when used in the cathode materials of sodium-ion batteries, enabled the batteries to achieve a capacity retention rate of over 90% after 50 cycles under the voltage range of 2 V to 4.15 V. In comparison with Examples 1-6, Comparative Example 1 exhibited poorer performance stability due to excessively high liquid feed flow rate and pyrolysis temperature, which enhanced particle thermal motion and increased interparticle collisions, leading to severe agglomeration of precursor particles and a dispersion degree below 0.467. In Comparative Example 2, the low liquid feed flow rate and pyrolysis temperature caused the initially wet particles to adhere more easily, forming larger particles, while electrostatic and van der Waals forces further promoted agglomeration, resulting in a dispersion degree below 0.467 and a capacity retention rate of only about 72%. In Comparative Example 3, the K-value exceeded 0.917, reaching 0.95, which also reduced the dispersion degree and led to poor cycling stability.

The above are only optional examples of the present application and are not intended to limit the present application. For those skilled in the art, the present application may have various modifications and changes. Any modifications, equivalent substitutions, improvements, etc. made within the spirit and principles of the present application should be included in the scope of the claims of the present application.

## Claims

1. A metal oxide precursor, **characterized in that** the metal oxide precursor comprises: dispersed single-crystal particles, and agglomerate particles formed by some of the single-crystal particles;
wherein a dispersion degree K of the metal oxide precursor is 0.467 to 0.917, and K=D₅₀/(η×D₉₀), in which, D₅₀ is a particle size at which a cumulative particle size distribution percentage of the metal oxide precursor reaches 50%, D₉₀ is a particle size at which the cumulative particle size distribution percentage of the metal oxide precursor reaches 90%, and η is a volume deviation coefficient and η=0.6.

2. The metal oxide precursor according to claim 1, wherein 1.5 µm ≤ D₅₀ ≤ 4.0 µm.

3. The metal oxide precursor according to claim 1, wherein 4 µm ≤ D₉₀ ≤ 10 µm.

4. The metal oxide precursor according to any one of claims 1-3, wherein the dispersion degree K of the metal oxide precursor is 0.5 to 0.9.

5. The metal oxide precursor according to claim 4, wherein the dispersion degree K of the metal oxide precursor is 0.6 to 0.8.

6. The metal oxide precursor according to claim 1, wherein a specific surface area of the metal oxide precursor is 4 m²/g to 12 m²/g.

7. The metal oxide precursor according to claim 1, wherein an apparent density of the metal oxide precursor is 0.4 g/cm³ to 1.2 g/cm³.

8. The metal oxide precursor according to claim 1, wherein a tap density of the metal oxide precursor is 1.0 g/cm³ to 2.5 g/cm³.

9. The metal oxide precursor according to claim 1, wherein an equivalent diameter of the agglomerate particles is 5 to 30 times a particle size of the single-crystal particles.

10. The metal oxide precursor according to claim 1, wherein in the metal oxide precursor, the dispersion degree of a single agglomerate particle is K=S₂/nS₁, in which, S₁ is a surface area of a single single-crystal particle in single agglomerate particle, n is a number of single-crystal particles in the agglomerate particle, and S₂ is a surface area of the agglomerate particle.

11. The metal oxide precursor according to claim 1, wherein a chemical formula of the metal oxide precursor is MnₐM₁₋ₐO₂, in which, 0.1 ≤ a ≤ 0.9, and M is selected from at least one of Ni, Fe, Cu, Zn, Co, Mg, Al, and Ti.

12. The metal oxide precursor according to claim 1, wherein a metal content of the metal oxide precursor is greater than or equal to 70%.

13. A preparation method for the metal oxide precursor according to any one of claims 1-12, wherein the preparation method adopts spray pyrolysis.

14. The preparation method for the metal oxide precursor according to claim 13, wherein a pyrolysis temperature of the spray pyrolysis is 500°C to 1000°C.

15. The preparation method for the metal oxide precursor according to claim 13, wherein a frequency of a feed device of the spray pyrolysis is 25 Hz to 45 Hz.

16. The preparation method for the metal oxide precursor according to claim 13, wherein a flow rate of the feed device of the spray pyrolysis is 0.3 m³/hr to 0.7 m³/hr.

17. A cathode material made from the metal oxide precursor according to any one of claims 1-12 or the metal oxide precursor prepared by the preparation method according to any one of claims 13-16.

18. A cathode plate, comprising: a cathode current collector, and a cathode material layer, which is disposed on a surface of the cathode current collector and comprises the cathode material according to claim 17.

19. A secondary battery, comprising a cathode plate according to claim 18.
